(19) Europäisches Patentamt
European Patent Office
Office européen des brevets

(11) **EP 4 597 747 A1**

(12) **EUROPEAN PATENT APPLICATION**

(43) Date of publication:
**06.08.2025 Bulletin 2025/32**

(21) Application number: **24221774.3**

(22) Date of filing: **19.12.2024**

(51) International Patent Classification (IPC):
*H01Q 3/01* (2006.01)    *H01Q 1/36* (2006.01)

(52) Cooperative Patent Classification (CPC):
**H01Q 1/368; H01Q 3/01**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.02.2024 US 202418432281**

(71) Applicant: **The Boeing Company**
**Arlington, VA 22202 (US)**

(72) Inventors:
• **Samara, Joseph**
**Arlington, 22202 (US)**
• **Chandra, Nitish**
**Arlington, 22202 (US)**

(74) Representative: **Witte, Weller & Partner**
**Patentanwälte mbB**
**Postfach 10 54 62**
**70047 Stuttgart (DE)**

(54) **PRINTED MECHANICAL ANTENNAS AND METHODS FOR MAKING PRINTED MECHANICAL ANTENNAS**

(57)    A printed mechanical antenna includes a mechanical actuator. The mechanical actuator includes a first side and a second side. The printed mechanical antenna also includes a first antenna structure printed on the first side using a conductive ink. The printed mechanical antenna further includes a second antenna structure printed on the second side using the conductive ink.

FIG. 4

EP 4 597 747 A1

**Description**

FIELD

The present disclosure relates generally to antennas and, more particularly, printed mechanical antennas and methods for making and using printed mechanical antennas.

BACKGROUND

Prior solutions to provide an electrically small antenna that operates in low frequency regimes have been unsuccessful. Electrical antennas that operate in low frequency ranges (e.g., MHz) are relatively large (e.g., approximately 10 meters long). Thus, low frequency electrical antennas have limited applications. Accordingly, those skilled in the art continue with research and development efforts in the field of antennas.

SUMMARY

Disclosed are examples of a printed mechanical antenna, a radio frequency device, a method for making a printed mechanical antenna, and a method for transmitting a radio frequency. The following is a non-exhaustive list of examples, which may or may not be claimed, of the subject matter according to the present disclosure.

In an example, the disclosed antenna includes a mechanical actuator. The mechanical actuator includes a first side and a second side. The antenna includes a first antenna structure printed on the first side using a conductive ink. The antenna includes a second antenna structure printed on the second side using the conductive ink.

In an example, the disclosed device includes a voltage source and an antenna. The antenna is electrically coupled to the voltage source. The antenna includes a mechanical actuator. The mechanical actuator includes a first side and a second side. The antenna includes a first antenna structure printed on the first side using a conductive ink. The antenna includes a second antenna structure printed on the second side using the conductive ink. The antenna transmits a radio frequency signal via kinematic motion of the first antenna structure and the second antenna structure caused by actuation of the mechanical actuator.

In an example, the disclosed method for making an antenna includes steps of: (1) providing a mechanical actuator; (2) inkjet printing a first antenna structure on a first side of the mechanical actuator using a conductive ink; and (3) inkjet printing a second antenna structure on a second side of the mechanical actuator using the conductive ink.

In an example, the disclosed method for transmitting a radio frequency signal includes steps of:

(1) applying a voltage to an antenna, the antenna includes a mechanical actuator that includes a first side and a second side, a first antenna structure that is printed on the first side using a conductive ink, and a second antenna structure that is printed on the second side using the conductive ink; (2) actuating the mechanical actuator in response to the applying the voltage; and

(3) transmitting the radio frequency signal via kinematic motion of the first antenna structure and the second antenna structure caused by actuating the mechanical actuator.

Other examples of the antenna, radio frequency device, and methods will become apparent from the following detailed description, the accompanying drawings, and the appended claims.

BRIEF DESCRIPTION OF THE DRAWINGS

Fig. 1 is a schematic block diagram of an example of a printed mechanical antenna;

Fig. 2 is a flow diagram of an example of a method for making the printed mechanical antenna;

Fig. 3 is a flow diagram of an example of a method for transmitting a radio frequency signal;

Fig. 4 is a schematic illustration of an example of the printed mechanical antenna;

Fig. 5 is a schematic illustration of linear oscillation of the example of the printed mechanical antenna shown in Fig. 4;

Fig. 6 is a schematic illustration of an example of the printed mechanical antenna;

Fig. 7 is a schematic illustration of radial oscillation of the example of the printed mechanical antenna shown in Fig. 6;

Fig. 8 is a schematic illustration of an example of an antenna structure of the printed mechanical antenna;

Fig. 9 is a schematic, enlarged illustration of an example of a portion of the antenna structure shown in Fig. 8;

Fig. 10 is a schematic illustration of an example of a proposed electromagnetic-mechanical metamaterial coupling;

Fig. 11 is a graphical representation of wave impedance vs. antenna electrical size;

Fig. 12 is a schematic illustration of an example of disoriented graphene particles of the ink-printed antenna structure of the printed mechanical antenna;

Fig. 13 is a schematic illustration of an example of aligned graphene particles of the ink-printed antenna structure of the printed mechanical antenna;

Fig. 14 is a flow diagram of an example of an aircraft manufacturing and service method; and

Fig. 15 is a schematic illustration of an example of an aircraft.

DETAILED DESCRIPTION

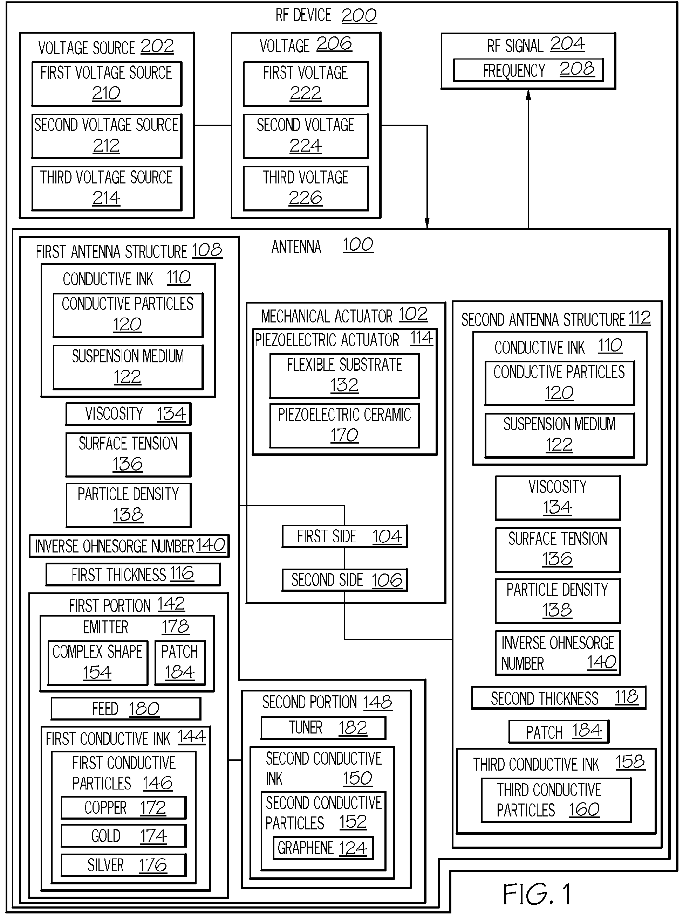

Referring generally to Figs. 1-13, by way of examples, the present disclosure is directed to a printed mechanical antenna 100, a radio frequency (RF) device 200 that utilizes the printed mechanical antenna 100, a method 1000 for making the printed mechanical antenna 100, and a method 2000 for transmitting a radio frequency signal using the printed mechanical antenna 100.

Examples of the printed mechanical antenna 100 replace an oscillating current with a mechanical motion of antenna, which thereby decouples the electrical radiation from electrical size required for efficient operation of an antenna with mechanical motion caused by actuation of the mechanical antenna. Examples of the printed mechanical antenna 100, the radio frequency device 200, the method 1000, and the method 2000 provide a solution to increase a transmission bandwidth of an antenna, which is achieved by the design of a mechanical actuator and the shape of an emitter that is printed on a surface of the mechanical actuator. Without being limited to any particular theory, the disclosed electromechanical antenna may provide a technique to circumvent fundamental limits of electrically small antenna radiation. Advantages of the disclosed antenna are enabled by printing antenna structures on surfaces of mechanical actuators, printing antenna structures with complex shapes, printing antenna structures that are tunable within a range of frequencies, and printing antenna structures that are capable of withstanding repeated mechanical actuation of the mechanical actuators.

Referring now to Figs. 1 and 4-13, the following are examples of the printed mechanical antenna 100, or electromechanical antenna or mechtenna, according to the present disclosure. The printed mechanical antenna 100 is also referred to herein as "antenna" 100. The antenna 100 includes a number of elements, features, and components. Not all of the elements, features, and/or components described or illustrated in one example are required in that example. Some or all of the elements, features, and/or components described or illustrated in one example can be combined with other examples in various ways without the need to include other elements, features, and/or components described in those other examples, even though such combination or combinations are not explicitly described or illustrated by example herein.

Fig. 1 schematically illustrates an example of the antenna 100. As will be described in more detail herein, in various examples, the antenna 100 includes one or more of a mechanical actuator 102, a first antenna structure 108, and a second antenna structure 112. In various examples, the first antenna structure 108 and/or the second antenna structure 112 are printed on the mechanical actuator 102 using conductive ink 110.

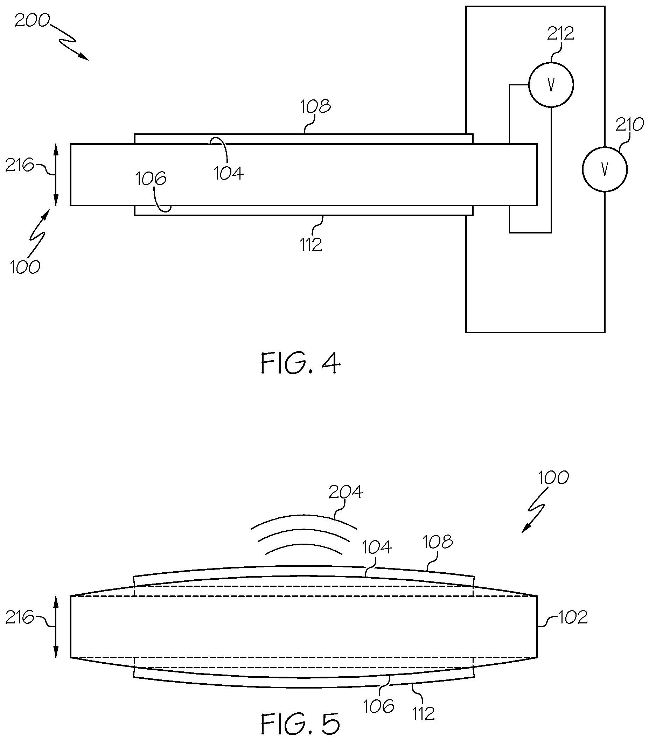

Figs. 4-7 schematically illustrate examples of the antenna 100. In one or more examples, the first antenna structure 108 and the second antenna structure 112 are printed on surfaces of the mechanical actuator 102. In one or more examples, the first antenna structure 108 and the second antenna structure 112 are created by graphene elements applied (e.g., printed) on the surface of an outer, insulated layer of the mechanical actuator 102. In one or more examples, oscillatory movement of the surface of the mechanical actuator 102 accelerates the first antenna structure 108, which is on the surface and is loaded with thin electrically biased graphene elements, which results in electromagnetic radiation.

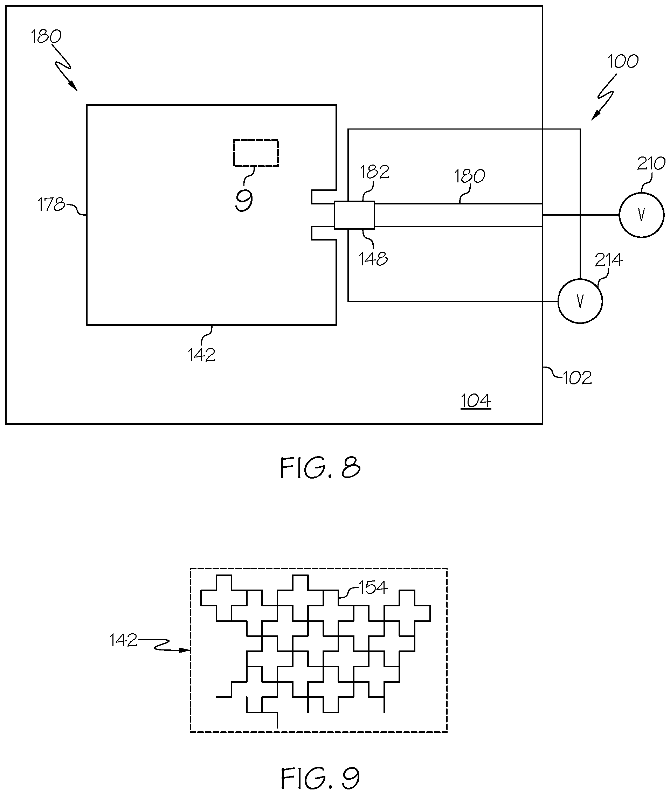

Figs. 8 and 9 schematically illustrate examples of the antenna 100. In one or more examples, the antenna 100 is reconfigurable. In one or more examples, the first antenna structure 108 includes a tunable graphene portion for broadband impedance matching. In one or more examples, the first antenna structure 108 includes an emitter portion that has a complex shape. Use of the tunable graphene portion and the complex-shaped emitter portion enables selective control over current distribution to optimize the radiation pattern of the antenna 100.

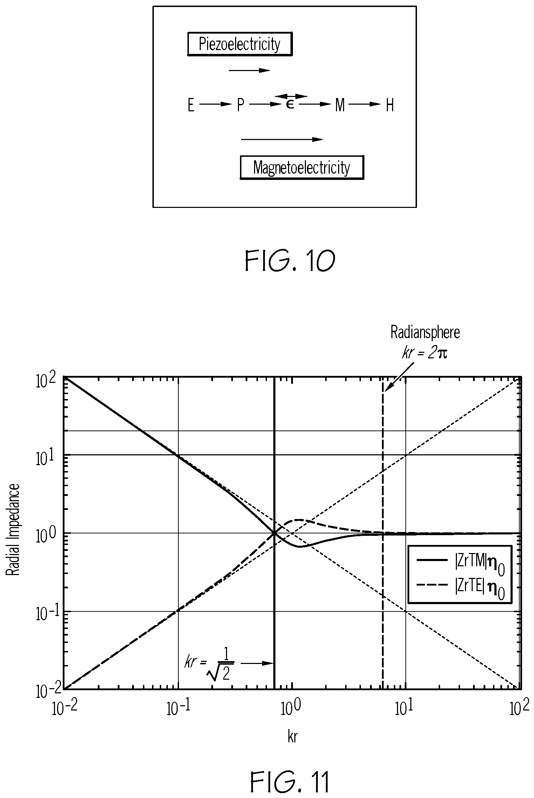

Fig. 10 is a theoretical schematic of a proposed electromagnetic-mechanical metamaterial coupling intermingling multi-physics domains to enable breaking through the linear time-invariant (LTI) Chu-limit. Fig. 11 is a graphical representation of wave impedance vs. antenna electrical size. A near-to-far-field transition region extends beyond the physical size of the antenna 100 (Chu-sphere).

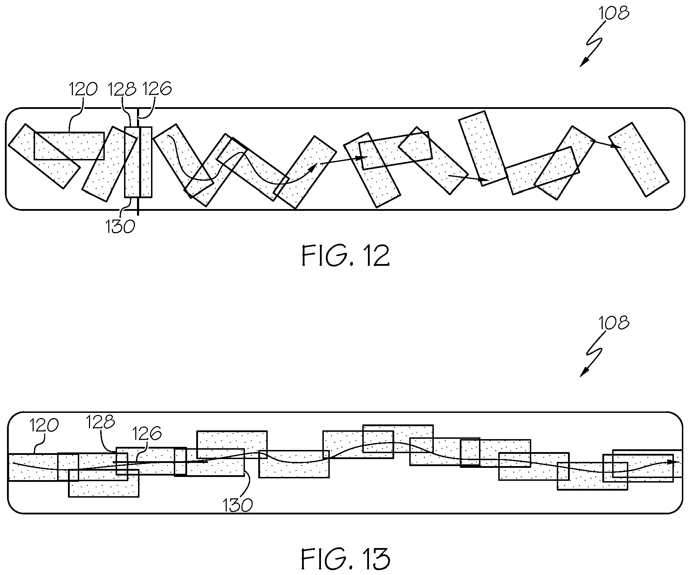

Fig. 12 and 13 schematically illustrate examples of different orientation configurations of graphene particles of conductive ink used to form the tunable graphene portion of the first antenna structure 108. In one or more examples, electronic alignment of ink printer droplets enhances the print quality for high surface conductivity and low loss reconfigurability.

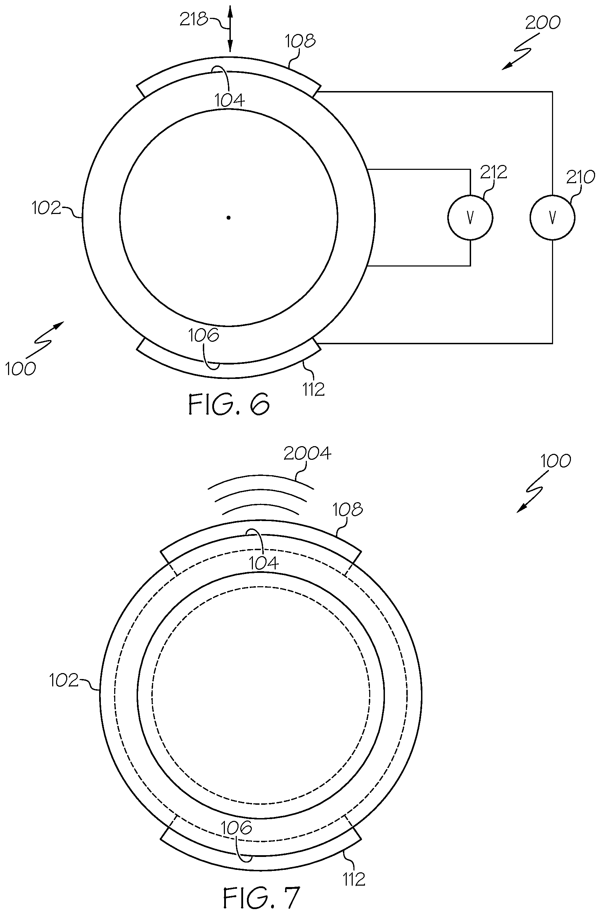

Referring generally to Figs. 1 and particularly to Figs. 4-7, in one or more examples, different oscillatory motions or modes (e.g., linear in Figs. 4 and 5 and radial in Figs. 6 and 7) of the first antenna structure 108 and the second antenna structure 112 (e.g., radiator, emitter, or charge reservoir) caused by actuation of the mechanical actuator 102 enables the antenna 100 to access different frequencies or frequency ranges. In other words, radiation of the radio frequency signal 204 results from oscillation of charges and/or currents in the first antenna structure 108 and/or second antenna structure 112. Radiation depends on oscillation of charges. Charge oscillation depends on speed of actuation and speed of displacement, which provides velocity. With a known velocity, the frequency of radiation can be mathematically calculated. Accordingly, the different modes or motions of the mechanical antenna 100 provide varying and/or selected speeds and/or displacements of oscillation, which enables radiation of the radio frequency signal 204 at different frequencies.

The present disclosure recognizes that prior efforts to increase bandwidth of operation and miniaturize electrically small antennas (ESAs) have utilized enlarging antenna volume for LTI systems, active elements for non-Foster circuits, and time-varying components to engineer the stored energy. Since the LTI system is still limited by the lower bound on the radiation Q-factor, the antenna can best approach the possible largest bandwidth (lowest Q-factor bound), and it cannot exceed the Chu-limit. Electrically small antennas have high capacitance and low radiation resistance requiring very high powers to excite them. It is noteworthy that LTI system limits do not necessarily apply to non-LTI systems or systems where active components are involved since the Q-factor of those systems is not clearly defined. Active elements in antennas (non-Foster elements) have proved difficult to design and incorporate to meet specifications as they increase the noise figure and nonlinearity in non-Foster circuits' elements create issues of power handling. The performance of such methods is limited by charge carriers and piezo elements that have difficulties in providing the necessary power and modulation mechanisms required. Knowledge of fundamental approaches to addressing linearity, passivity and non-reciprocity have only recently emerged from metamaterial studies by optimizing the bianisotropic material tensor and magnetoelectric coupling in heterostructures enabled by mechanical actuation.

In one or more examples of the antenna 100, mechanical motion is used to create a current density to generate radiated fields. The current density is a product of the motion and the shape of the charge reservoir (e.g., first antenna structure 108). The antenna 100 provides distinct advantages for electrically small antennas at lower frequency range such as HF (HighFrequency). Two key inputs are reactance and radiation resistance. Mechanical modulation eases the issue of input reactance for broadband electrically small antenna. A key element of the antenna 100 is the charge reservoir (e.g., the first antenna structure 108). To maximize antenna efficiency, the space charge surface density or volume density of the emitter portion of the antenna structure should be as high as possible (e.g., as shown in Fig. 11). Examples of the types of motion and charge for various examples of the antenna 100 include: linear mechtenna with linear motion of the space charge; and radial mechtenna with radial motion of polarized charge;. In one or more examples, the charge reservoir (e.g., first antenna structure 108) is fabricated using ink printing technology. In one or more examples, conductive inkjet printing provides a cost-effective and scalable way to create a conductive path on a flexible and conformal substrate of the mechanical actuator 102. The quality of conductive ink 110 and the thickness of the first antenna structure 108 across the geometry is key to decrease ohmic response and uniformity of surface current distribution.

In one or more examples of the antenna 100, the conductive ink 110 is coupled with the mechanical actuator 102 (e.g., a piezoelectric actuator), which depends on various factors such as suitable ink viscosity range. In one or more examples, the first antenna structure 108 and/or the second antenna structure 112 (e.g., the conductive layers) have uniform thickness to ensure efficient radiation from the antenna 100. In one or more examples, using a drop-on-demand (DOD) inkjet printing, the conductive inks 110 have the ability to generate droplets. The droplets ejecting out from a nozzle of an inkjet print head are influenced by ink viscosity $\eta$ (mPa s), surface tension $\gamma$ (mN/m), particle density $\rho$ (gcm-3), and nozzle diameter $a$ ($\mu$m). In one or more examples, for desired inkjet printing of the conductive ink 110, the inverse Ohnesorge number ($Z = Oh^{-1}$) is used as the figure of merit (FOM) to characterize the drop formation and jettability of the conductive ink 110. Z is calculated using $Z = \sqrt{\gamma \rho a} / \eta$ and an optimal range of Z between 1 to 10 is desirable for stable DOD printing.

In one or more examples, the antenna 100 utilizes bianisotropic materials. Bianisotropic materials are electromagnetic media that possess intrinsic mechanisms of magnetoelectric coupling. Use of bianisotropic materials allow coupling between electric and magnetic fields through magnetoelectric coupling, which is functionalized through the mechanical actuator 102 (Fig. 10). By embedding an antenna (e.g., first antenna structure 108) in such a material (e.g., mechanical actuator 102) and leveraging the magnetoelectric (ME) coupling, the near field may extend beyond the physical size of the antenna (Fig. 11). Hence, for HF antenna it is desirable to engineer the near field using magnetoelectric coupling to enhance radiation efficiencies during miniaturization. To ensure uniform performance across a band of frequencies, it is desirable to account for dispersion. Examples of the antenna may have ohmic losses and inefficiencies. In one or more examples, interplay between loss and dispersion of materials can be leveraged to overcome the Chu-limit. In addition to incorporating temporal dispersion (frequency-dependent), examples of the disclosed antenna introduce spatial dispersion (wavenumber-dependence) in the cross-coupling terms ($\overleftrightarrow{\xi}(\omega,\boldsymbol{k})$ and $\overleftrightarrow{\zeta}(\omega,\boldsymbol{k})$) of the constitutive relations (Equations 1 and 2) in radiating systems to accurately determine the energy stored and increase the power radiated.

$$\boldsymbol{D}\,(\omega,\,\boldsymbol{k}) = \overleftrightarrow{\epsilon}(\omega,\,\boldsymbol{k}) \cdot \boldsymbol{E}(\omega,\boldsymbol{k}) + \overleftrightarrow{\xi}(\omega,\,\boldsymbol{k}) \cdot \boldsymbol{B}(\omega,\,\boldsymbol{k}) \qquad \text{(Equation 1)}$$

$$\boldsymbol{B}\,(\omega,\,\boldsymbol{k}) = \overleftrightarrow{\zeta}(\omega,\,\boldsymbol{k}) \cdot \boldsymbol{E}(\omega,\boldsymbol{k}) + \overleftrightarrow{\mu}(\omega,\,\boldsymbol{k}) \cdot \boldsymbol{B}(\omega,\,\boldsymbol{k}) \qquad \text{(Equation 2)}$$

Spatial dispersion creates a shift in the momentum of the materials in k-space. In real space, such materials are referred to as nonlocal materials because they affect the curl of electric and magnetic fields in Maxwell's equations. The nonlocal design breaks the strict dependence on the local resonance of the unit cells, allowing crafting of an elaborate frequency-wavenumber-dependent response that has broadband performance. Nonlocality or spatial dispersion can be engineered to enable signal manipulation in the momentum domain, reducing the Q-factor and impendence matching of antennas.

In one or more examples, the coupling interaction at the interface between different ferroic orders is known as the ME effect and is categorized as direct ME and converse ME effect. The direct ME effect results from changing electric polarization with an applied magnetic field. The converse ME effect occurs with a change in magnetization with an applied electric field. The ME effect is a product of the piezoelectric effect (induced mechanical strain from electric polarization) and the magnetoelastic effect (induced magnetization from mechanical strain). In multilayer heterostructures, an applied electric field on a piezoelectric material leads to the generation of a mechanical deformation (e.g., strain) that can be transferred to an adjacent magnetostrictive material. In one or more examples, operation of the antenna 100 relies on an applied oscillating voltage, for example, applied via interdigital electrodes. The applied voltage leads to associated mechanical vibrations or oscillations generated by pressure on the piezoelectric layers.

In one or more examples, the antenna 100 is reconfigurable by use of broadband impedance matching at the feed point (e.g., second portion 148 or tuner 182 of the first antenna structure 108 in Fig. 8). Optimization of radiation efficiency is obtained by engineering the shape and conductivity of the radiating element (e.g., a first portion 142 or emitter 178 of the first antenna structure 108 in Fig. 8). In one or more examples, graphene ink (e.g., the conductive ink 110 that includes particles of graphene 124) provides an advantageous solution to produce the antenna 100 that is inkjet printed and tunable. The conductivity of graphene 124 is controlled by an electric bias, which enables broadband impedance matching.

The present disclosure recognizes that conductive inkjet printing desired patterns allows a cost-effective vacuum- and lithography-free method. Further, examples of inkjet-printed mm-wave antennas often suffer from limitations present in typical multilayer RF structure design, such as the discrete thicknesses and material properties of common laminate substrates, as well as the difficulties of multilayer laminate substrate processing (e.g. material stacking, bonding, and alignment). The present disclosure further recognizes that the vertically integrated, additive nature of inkjet printing of antenna structures as disclosed herein, enables high-level integration with areas of high interest, such as system-on-chip (SoC) components, flexible wearable electronics, and conformal/ rollable/ reconfigurable structures. This integration has the potential to increase the efficiency and versatility of wireless radio-wave systems through the direct post-process deposit. Generally, inkjet printing is a process that involves spitting droplets of ink out of a printhead. The droplet size can be controlled by merging smaller droplets out of the printhead. Larger droplet size allows for greater throw distance and volume of material jetted while smaller droplet size allows for better resolution.

The present disclosure recognizes that inkjet printing has been used to manufacture various types of electrical antenna. However, inkjet printing has never before been used to manufacture a mechanical antenna. Manufacturing a mechanical antenna with inkjet printing comes with a novel set of challenges. One of these challenges is accounting for mechanical deformation of the jetted material. The two methods of mechanical failure that are of most concerns are cracking and delamination. Most thermoplastic polymers observe hyperelastic behavior, which means that a small amount of strain does not induce much stress. Assuming perfect adhesion and uniform actuation of piezoelectric, $\sigma = \dfrac{F}{A}$, $\varepsilon = \delta/L$,

and $\sigma = E\varepsilon$. So $\varepsilon = \dfrac{EF}{A} = \delta/L$ . As a boundary condition, it can be assumed that the change in length of the ink is at least approximately equal to the change in length of the piezoelectric at the contact surface. Therefore, the ink is most likely to fail at the contact surface for a flat surface and most likely to fail at the portion exposed to the air for a cylindrical surface. Because the antenna 100 utilizes oscillation through actuation of the mechanical actuator 102, fatigue is considered and the fatigue total damage equation can be used, where $n_j$ is the number of fatigue cycles and $N_j$ is lifetime, failure occurs when:

$$\sum_{j=1}^{n} \frac{n_j}{N_j} = 1$$

The fatigue life depends on the magnitude of the forces and materials involved and, thus, empirical data is collected in order to model fatigue life for different force magnitudes. To optimize the fatigue life of the conductive ink 110 used to form the first antenna structure 108 and/or the second antenna structure 112 of the antenna 100, graphene ink can be used as previous data has shown that it can increase the fatigue life of materials. In one or more examples, adhesion can be determined by calculating the relative surface energies of the liquids. This is used to determine the strength of adhesive contacts and can be determined empirically by detaching bodies of a well-defined shape from a known substrate material. The present disclosure also recognizes that another challenge of printing on a mechanical antenna is to maximize the conductivity of the ink to in turn maximize the power output of the antenna. In one or more examples of the antenna 100, the conductivity of the conductive ink 110 is increased without changing its composition. This is achieved by aligning conductive particles 120 in the conductive ink 110 so that they are interconnected (e.g., as shown in Fig. 13), which in turn creates more pathways for electrons to travel through. One mechanism that can be used to align the conductive particles 120 is electrophoresis. In one or more examples, the printed graphene ink is subjected to an electric field that aligns the graphene particles, sheets, or ribbons so they overlap more.

Referring generally to Fig. 1 and particularly to Figs. 4-7, in one or more examples, the antenna 100 includes the mechanical actuator 102. The mechanical actuator 102 includes a first side 104 and a second side 106. The mechanical antenna 100 includes the first antenna structure 108. The first antenna structure 108 is printed on the first side 104 using the conductive ink 110. The mechanical antenna 100 includes the second antenna structure 112. The second antenna structure 112 is printed on the second side 106 using the conductive ink 110.

Referring to Fig. 1, in one or more examples, the mechanical actuator 102 includes or takes the form of a piezoelectric actuator 114. In one or more examples, the piezoelectric actuator 114 includes a flexible substrate 132. In one or more examples, the piezoelectric actuator 114 includes a piezoelectric ceramic 170. As an example, the piezoelectric ceramic 170 of the flexible substrate 132 is lead zirconate titanate (PZT). Other ceramic perovskite materials or ferroelectric ceramic materials that exhibit a piezoelectric effect are also contemplated for use as the mechanical actuator 102. Generally, the material of the mechanical actuator 102, such as of the piezoelectric ceramic 170, is selected to be compatible with the conductive ink 110 used to form the first antenna structure 108 and the second antenna structure 112 that are printed on the mechanical actuator 102. For example, the material of the mechanical actuator 102, such as of the piezoelectric ceramic 170, is selected to enable desired or suitable adhesion between the conductive ink 110 and the surface of the mechanical actuator 102. In one or more examples, the mechanical actuator 102, such as the piezoelectric actuator 114, has any suitable cross-sectional geometry, such as square, rectangular, circular, elliptical, and the like. The geometry of the mechanical actuator 102 may depend on the oscillation speed and displacement desired to be produced by the mechanical actuator 102, the mode or motion of the mechanical actuator 102, the material selection of the flexible substrate 132, and the like.

Referring to Fig. 1, in one or more examples, the conductive ink 110 includes conductive particles 120 that are mixed (e.g., suspended, dispersed, etc.) in a suspension medium 122. In one or more examples, the conductive particles 120 include or take the form of graphene 124. In one or more examples, the conductive particles 120 include or take the form of copper 172. In one or more examples, the conductive particles 120 include or take the form of silver 176. In one or more examples, the conductive particles 120 include or take the form of gold 174. Other suitable conductive materials are also contemplated for use as the conductive particles 120 of the conductive ink 110. Generally, the suspension medium 122 is typical of commercially available conductive inks. In one or more examples, the suspension medium 122 is a solvent-based medium.

Referring to Fig. 1, in one or more examples, the conductive ink 110, such as the suspension medium 122, includes a viscosity 134, a surface tension 136, and a particle density 138. The viscosity 134, the surface tension 136, and/or the particle density 138 can vary by application and intended use of the conductive ink 110. Generally, the viscosity 134, the surface tension 136, and/or the particle density 138 of the conductive ink 110 are typical of other commercially available conductive inks. In one or more examples, the conductive ink 110 includes an inverse Ohnesorge number 140 that is typical of commercially available conductive inks, such as between approximately 1 Oh$^{-1}$ and 10 Oh$^{-1}$.

Referring generally to Fig. 1 and particularly to Figs. 12 and 13, which illustrate examples of the conductive particles 120 of the conductive ink 110 forming the first antenna structure 108 of the mechanical antenna 100. In one or more examples, each of the conductive particles 120 includes a long axis 126, a first end 128, and a second end 130, opposite the first end 128 along the long axis 126. In one or more examples, the conductive particles 120, such as graphene 124, are anisotropic having different properties of characteristics along different axes or depending on direction.

Referring generally to Fig. 1 and particularly to Fig. 12, in one or more examples, the conductive particles 120 of the first antenna structure 108 are randomly oriented. In one or more examples, the conductive particles 120 of the second antenna structure 112 are also randomly oriented. As will be described herein below and illustrated by example in Fig. 13, in one or more examples, the conductive particles 120 of the first antenna structure 108 and/or the conductive particles 120 of the second antenna structure 112 can be aligned using electrophoresis (e.g., electrophoretic alignment).

Referring generally to Fig. 1 and particularly to Fig. 13, in one or more examples, the conductive particles 120 of the first antenna structure 108 are aligned such that the first end 128 of one of the conductive particles 120 is in contact with the second end 130 of a directly adjacent one of the conductive particles 120 and the long axis 126 of the one of the conductive particles 120 is at least approximately parallel to the directly adjacent one of the conductive particles 120.

In one or more examples, the conductive particles 120 of the second antenna structure 112 are aligned such that the first end 128 of one of the conductive particles 120 is in contact with the second end 130 of a directly adjacent one of the conductive particles 120 and the long axis 126 of the one of the conductive particles 120 is at least approximately parallel to the directly adjacent one of the conductive particles 120.

Referring generally to Fig. 1 and particularly to Fig. 8, which illustrates an example of the first antenna structure 108 printed on the first side 104 of the mechanical actuator 102. In one or more examples, the first antenna structure 108 includes at least a first portion 142 and a second portion 148. The first portion 142 is printed on the first side 104 using a first conductive ink 144 that includes first conductive particles 146. The second portion 148 is printed on the first side 104 using a second conductive ink 150 that includes second conductive particles 152. In these examples, the first conductive particles 146 and the second conductive particles 152 are different. In one or more examples, the first conductive particles 146 of the first conductive ink 144 include at least one of copper 172, gold 174, and silver 176. In one or more examples, the second conductive particles 152 of the second conductive ink 150 include graphene 124. In one or more examples, the first portion 142 takes the form of or serves as the emitter 178 (e.g., radiator) of the antenna 100. In one or more examples, the second portion 148 takes the form of or serves as the tuner 182 of the antenna 100.

Referring to Figs. 1 and 8, in one or more examples, at least some part of the first portion 142 of the first antenna structure 108 includes or takes the form of a patch 184. In these examples, the patch 184 is a solid, continuous structure printed on the first side 104 of the mechanical actuator 102.

Referring generally to Fig. 1 and particularly to Fig. 9, which illustrates the structure of an example of the first portion 142 of the first antenna structure 108 shown in Fig. 8. In one or more examples, at least some part of the first portion 142 of the first antenna structure 108 includes or takes the form of a complex shape 154. In these examples, the complex shape 154 is a structure element that includes multiple segments or pathways with gaps or openings therebetween. The printed segments or pathways of the can include lines, arcs, points, and the like. The complex shape 154 is designed and/or selected enhance radiation efficiency of the first antenna structure 108 of the mechanical antenna 100. In one or more examples, the design and/or features of the complex shape 154 are optimized using a suitable computational application.

In one or more examples, the second portion 148, including the second conductive particles 152 made of graphene 124, enables frequency tuning of the antenna 100. In one or more examples, the second portion 148 has a direct current (DC) bias that is used to tune the conductivity of the graphene 124. In the graphene 124, conductivity is a function of frequency. Therefore, the voltage 206 (e.g., third voltage 226) from the voltage source 202 (e.g., third voltage source 214) is used to change the conductivity of the graphene 124 and, thus, change the frequency. As an example, changing the conductivity of the second portion 148 positioned between the electrode (e.g., feed) and the first portion 142 enables maintaining a desired reflection throughout different frequencies or frequency ranges (e.g., 33%).

In one or more examples, the first antenna structure 108 is the radiator or emitter of the antenna 100. The second antenna structure 112 is or serves as a ground plane of the antenna 100 that provides directionality to the antenna 100. The second antenna structure 112 includes or takes the form of a patch or solid, continuous structure of material printed on the second side 106 of the mechanical actuator 102 using the conductive ink 110.

In one or more examples, the entirety of the first antenna structure 108 is made of one or more of graphene 124, copper 172, gold 174, and/or silver 176, or another appropriate conductive material. In one or more examples, the entirety of the second antenna structure 112 is made of one or more of graphene 124, copper 172, gold 174, and/or silver 176, or another appropriate conductive material.

In one or more examples, the second antenna structure 112 is printed on the second side 106 using a third conductive ink 158 that includes third conductive particles 160. In one or more examples, the third conductive particles 160 of the third conductive ink 158 include at least one of copper 172, gold 174, and silver 176.

Referring generally to Fig. 1 and particularly to Fig. 8, in one or more examples, the first antenna structure 108 includes the emitter 178 and a feed 180. The feed 180 is or is coupled to the electrode of the voltage source 202, such as a first voltage source 210. In one or more examples, the first antenna structure 108 also includes the tuner 182. The tuner 182 extends between the emitter 178 and the feed 180. In one or more examples, the emitter 178 and the feed 180 include at least one of copper 172, silver 176, and gold 174. In one or more examples, the tuner 182 includes graphene 124.

Referring to Fig. 1, in one or more examples, the first antenna structure 108 includes a first thickness 116. The first thickness 116 is constant along the first side 104. In one or more examples, the second antenna structure 112 includes a second thickness 118. The second thickness 118 is constant along the second side 106. In one or more examples, the first thickness 116 and the second thickness 118 are the same. In one or more examples, the first thickness 116 and the second thickness 118 are different.

Referring generally to Fig. 1 and particularly to Figs. 4 and 5, in one or more examples, the mechanical actuator 102 produces linear motion (e.g., in the directions of directional arrow 216 in Fig. 4). In other words, in one or more examples, the antenna 100 has a linear mode of oscillation as described herein above.

Referring generally to Fig. 1 and particularly to Fig. 6 and 7, in one or more examples, the mechanical actuator 102 produces radial motion (e.g., in the directions of directional arrow 218 in Fig. 6). In other words, in one or more examples, the antenna 100 has a radial mode of oscillation as described herein above.

In one or more examples, the mechanical actuator 102 produces a combination of linear motion and radial motion.

Referring now to Figs. 1 and 4-13, the following are examples of the radio frequency device 200, according to the present disclosure. The radio frequency device 200 is also referred to herein as "device" 200. The device 200 includes a number of elements, features, and components. Not all of the elements, features, and/or components described or illustrated in one example are required in that example. Some or all of the elements, features, and/or components described or illustrated in one example can be combined with other examples in various ways without the need to include other elements, features, and/or components described in those other examples, even though such combination or combinations are not explicitly described or illustrated by example herein.

Referring generally to Fig. 1 and particularly to Fig. 8, in one or more examples, the device 200 includes the voltage source 202 and the mechanical antenna 100. The antenna 100 is electrically coupled to the voltage source 202. For example, the mechanical antenna 100 is coupled to and is in electrical communication with the voltage source 202. In one or more examples, the antenna 100 includes the mechanical actuator 102, the first antenna structure 108, and the second antenna structure 112. The mechanical actuator 102 includes the first side 104 and the second side 106. The first antenna structure 108 is printed on the first side 104 using the conductive ink 110. The second antenna structure 112 is printed on the second side 106 using the conductive ink 110. The antenna 100 transmits a radio frequency signal 204 via kinematic motion of the first antenna structure 108 and the second antenna structure 112 caused by actuation of the mechanical actuator 102.

Referring generally to Fig. 1 and particularly to Figs. 4-7, in one or more examples, the mechanical actuator 102 is coupled to and is in electrical communication with the voltage source 202, such as a second voltage source 212. In these examples, the voltage 206, such as the second voltage 224 at a desired frequency, is applied to mechanical actuator 102 and is converted to oscillatory kinematic motion, such as oscillatory linear motion (e.g., in the direction of directional arrow 216 in Fig. 4), oscillatory radial motion (e.g., in the direction of directional arrow 218 in Fig. 6). In one or more examples, the first antenna structure 108 and the second antenna structure 112 are coupled to and in electrical communication with the voltage source 202, such as the first voltage source 210. In these examples, the voltage 206, such as the first voltage 222 at a desired frequency, is applied to the first antenna structure 108 and the second antenna structure 112 and is converted to a radio frequency (RF) signal, such as the radio frequency signal 204. The oscillatory motion produced by the mechanical actuator 102 radiates the radio frequency signal 204 generated by the first antenna structure 108 and the second antenna structure 112.

Referring to Fig. 1, in one or more examples of the radio frequency device 200, the mechanical actuator 102 includes the piezoelectric actuator 114. In one or more examples of the radio frequency device 200, the piezoelectric actuator 114 includes the flexible substrate 132. In one or more examples of the radio frequency device 200, the piezoelectric actuator 114 includes the piezoelectric ceramic 170.

Referring to Fig. 1, in one or more examples of the radio frequency device 200, the conductive ink 110 includes the conductive particles 120 embedded or otherwise mixed dispersed in the suspension medium 122.

Referring generally to Fig. 1 and particularly to Figs. 12 and 13, in one or more examples of the radio frequency device 200, each of the conductive particles 120 includes the long axis 126, the first end 128, and the second end 130, opposite the first end 128 along the long axis 126.

Referring generally to Fig. 1 and particularly to Fig. 12, in one or more examples of the radio frequency device 200, the conductive particles 120 of the first antenna structure 108 are randomly oriented.

Referring generally to Fig. 1 and particularly to Fig. 13, in one or more examples of the radio frequency device 200, the conductive particles 120 of the first antenna structure 108 are aligned such that the first end 128 of one of the conductive particles 120 is in contact with the second end 130 of a directly adjacent one of the conductive particles 120 and the long axis 126 of the one of the conductive particles 120 is at least approximately parallel to the directly adjacent one of the conductive particles 120.

In one or more examples of the radio frequency device 200, the conductive particles 120 of the second antenna structure 112 are also aligned such that the first end 128 of one of the conductive particles 120 is in contact with the second end 130 of a directly adjacent one of the conductive particles 120 and the long axis 126 of the one of the conductive particles 120 is at least approximately parallel to the directly adjacent one of the conductive particles 120.

Referring to Fig. 1, in one or more examples of the radio frequency device 200, the conductive particles 120 include graphene 124. In one or more examples of the radio frequency device 200, the conductive particles 120 include copper 172. In one or more examples of the radio frequency device 200, the conductive particles 120 include silver 176. one or more examples of the radio frequency device 200, the conductive particles 120 include gold 174.

Referring to Fig. 1, in one or more examples of the radio frequency device 200, the conductive ink 110 includes viscosity 134, surface tension 136, and particle density 138. In one or more examples, the conductive ink 110 includes the inverse Ohnesorge number 140 of between approximately 1 Oh$^{-1}$ and 10 Oh$^{-1}$.

Referring generally to Fig. 1 and particularly to Fig. 8, in one or more examples of the radio frequency device 200, the first antenna structure 108 includes the first portion 142 and the second portion 148. The first portion 142 is printed on the first side 104 using the first conductive ink 144. The first conductive ink 144 includes the first conductive particles 146. The second portion 148 that is printed on the first side 104 using the second conductive ink 150. The second conductive ink 150 includes the second conductive particles 152. The first conductive particles 146 and the second conductive particles 152 are different.

Referring to Fig. 1, one or more examples of the radio frequency device 200, the first conductive particles 146 of the first conductive ink 144 include at least one of copper 172, gold 174, and silver 176. In one or more examples of the radio frequency device 200, the second conductive particles 152 of the second conductive ink 150 includes graphene 124.

Referring generally to Fig. 1 and particularly to Figs. 8 and 9, in one or more examples of the radio frequency device 200, the first portion 142 of the first antenna structure 108 includes the complex shape 154.

Referring to Fig. 1, in one or more examples of the radio frequency device 200, the first antenna structure 108 includes the first thickness 116. In one or more examples, the first thickness 116 is constant along the first side 104. In one or more examples of the radio frequency device 200, the second antenna structure 112 includes the second thickness 118. In one or more examples, the second thickness 118 is constant along the second side 106.

Referring generally to Fig. 1 and particularly to Figs. 4 and 5, in one or more examples of the radio frequency device 200, the mechanical actuator produces linear motion.

Referring generally to Fig. 1 and particularly to Figs. 6 and 7, in one or more examples of the radio frequency device 200, the mechanical actuator 102 produces radial motion.

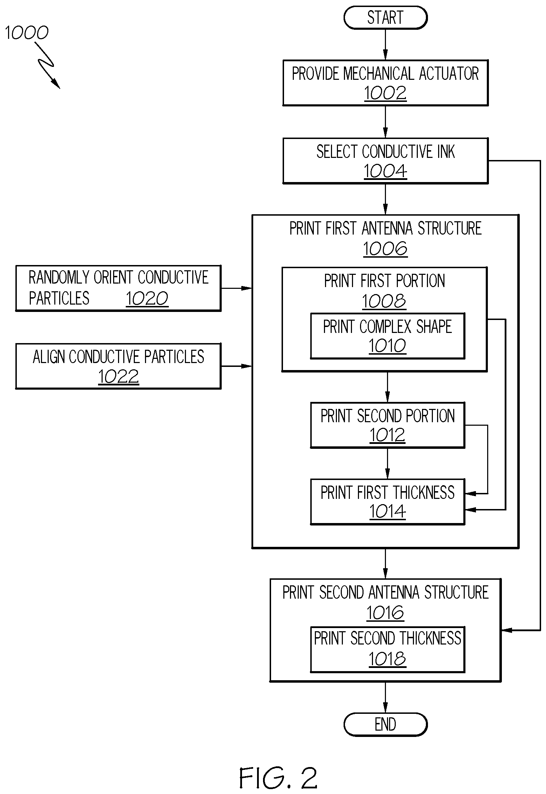

Referring now to Fig. 2, the following are examples of the method 1000 for making the antenna 100, according to the present disclosure. The method 1000 includes a number of elements, steps, operations, or processes. Not all of the elements, steps, operations, or processes described or illustrated in one example are required in that example. Some or all of the elements, steps, operations, or processes described or illustrated in one example can be combined with other examples in various ways without the need to include other elements, steps, operations, or processes described in those other examples, even though such combination or combinations are not explicitly described or illustrated by example herein.

Referring generally to Figs. 1 and 4-13 and particularly to Fig. 2, in one or more examples, the method 1000 includes a step of providing 1002 the mechanical actuator 102. The method 1000 includes a step of printing 1006 (e.g., inkjet printing) the first antenna structure 108 on the first side 104 of the mechanical actuator 102 using the conductive ink 110. The method 1000 includes a step of printing 1016 (e.g., inkjet printing) the second antenna structure 112 on the second side 106 of the mechanical actuator 102 using the conductive ink 110.

Referring generally to Figs. 1 and 12 and particularly to Fig. 2, in one or more examples, the method 1000 includes a step of randomly orienting 1020 the conductive particles 120 of the first antenna structure 108 during printing of the first antenna structure 108.

Referring generally to Figs. 1 and 13 and particularly to Fig. 2, in one or more examples, the method 1000 includes a step of aligning 1022 the conductive particles 120 of the first antenna structure 108 during printing of the first antenna structure 108. In these examples, the conductive particles 120 are aligned such that the first end 128 of one of the conductive particles 120 is in contact with the second end 130 of a directly adjacent one of the conductive particles 120 and the long axis 126 of the one of the conductive particles 120 is at least approximately parallel to the directly adjacent one of the conductive particles 120.

Referring generally to Figs. 1 and particularly to Fig. 2, in one or more examples, the method 1000 includes selecting 1004 the conductive ink 110. In one or more examples, selection of the conductive ink 110 includes selecting based on at least one of viscosity 134, surface tension 136, and particle density 138 of the conductive ink 110. In one or more examples, according to the method 1000, selection of the conductive ink 110 includes selecting based the inverse Ohnesorge number 140 of the conductive ink 110. In one or more examples, the inverse Ohnesorge number 140 of the conductive ink 110 is selected to be between approximately 1 Oh$^{-1}$ and 10 Oh$^{-1}$.

Referring generally to Fig. 1 and particularly to Fig. 2, in one or more examples, according to the method 1000, selection of the conductive ink 110 includes selecting based on a material composition of the conductive particles 120 of the conductive ink 110. In one or more examples, selection of the conductive ink 110 includes selecting the conductive ink 110 that includes the conductive particles 120 made of graphene 124. In one or more examples, selection of the conductive ink 110 includes selecting the conductive ink 110 that includes the conductive particles 120 made of copper 172. In one or more examples, selection of the conductive ink 110 includes selecting the conductive ink 110 that includes the conductive particles 120 made of silver 176. In one or more examples, selection of the conductive ink 110 includes selecting the conductive ink 110 that includes the conductive particles 120 made of gold 174.

Referring generally to Figs. 1 and 8 and particularly to Fig. 2, in one or more examples, according to the method 1000, the step of printing 1006 the first antenna structure 108 includes a step of printing 1008 the first portion 142 of the first antenna structure 108 on the first side 104 using the first conductive ink 144. The first conductive ink 144 includes or is selected to include the first conductive particles 146. The step of printing 1006 the first antenna structure 108 also includes a step of printing 1010 the second portion 148 of the first antenna structure 108 on the first side 104 using the second conductive ink 150. The second conductive ink 150 includes or is selected to include the second conductive particles 152. The first conductive particles 146 and the second conductive particles 152 are different.

Referring generally to Figs. 1, 8 and 9 and particularly to Fig. 2, in one or more examples, according to the method 1000, the step of printing 1006 the first antenna structure 108 includes a step of printing 1012 the first portion 142 in or having the complex shape 154.

Referring generally to Fig. 1 and particularly to Fig. 2, in one or more examples, the step of printing 1016 the second antenna structure 112 includes a step of printing the second antenna structure 112 on the second side 106 of the mechanical actuator 102 using a third conductive ink 158. The third conductive ink 158 includes or is selected to include third conductive particles 160. In one or more examples, the third conductive particles 160 of the third conductive ink 158 and the first conductive particles 146 of the first conductive ink 144 are different. In one or more examples, the third conductive particles 160 of the third conductive ink 158 and the first conductive particles 146 of the first conductive ink 144 are the same. In one or more examples, the third conductive particles 160 of the third conductive ink 158, the first conductive particles 146 of the first conductive ink 144, and the second conductive particles 152 of the second conductive ink 150 are different.

Referring to generally to Fig. 1 and particularly to Fig. 2, in one or more examples, according to the method 1000, the step of printing 1006 the first antenna structure 108 includes a step of printing 1014 the first antenna structure 108 having the first thickness 116. In one or more examples, the first antenna structure 108 is printed on the first side 104 of the mechanical actuator 102 such that the first thickness 116 is constant along the first side 104. In one or more examples, according to the method 1000, the step of printing 1016 the second antenna structure 112 includes a step of printing 1018 the second antenna structure 112 having the second thickness 118. In one or more examples, the second antenna structure 112 is printed on the second side 106 of the mechanical actuator 102 such that the second thickness 118 is constant along the second side 106.

Referring generally to Figs. 1 and 8 and particularly to Fig. 2, in one or more examples, according to the method 1000, the step of printing 1006 the first antenna structure 108 includes a step of printing the emitter 178 and the feed 180 on the first side 104 using the first conductive ink 144. The first conductive ink 144 includes the first conductive particles 146. The step of printing 1006 the first antenna structure 108 also includes a step of printing the tuner 182 on the first side 104 between the emitter 178 and the feed 180 using the second conductive ink 150. The second conductive ink 150 includes the second conductive particles 152. In one or more examples, the first conductive particles 146 include at least one of copper 172, silver 176, and gold 174. In one or more examples, the second conductive particles 152 include graphene 124.

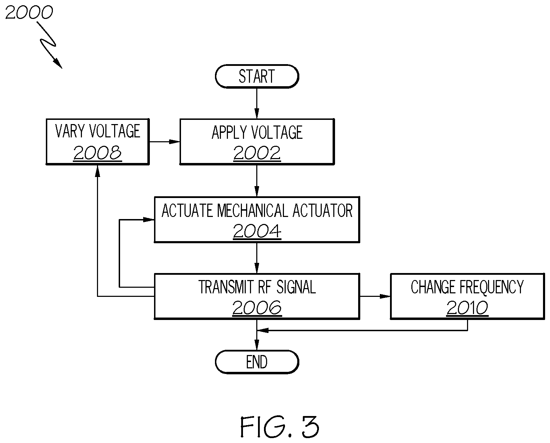

Referring now to Fig. 3, the following are examples of the method 2000 for transmitting the radio frequency signal 204, according to the present disclosure. In one or more examples, the method 2000 is implemented using the antenna 100 and/or device 200 (Fig. 1). The method 2000 includes a number of elements, steps, operations, or processes. Not all of the elements, steps, operations, or processes described or illustrated in one example are required in that example. Some or all of the elements, steps, operations, or processes described or illustrated in one example can be combined with other examples in various ways without the need to include other elements, steps, operations, or processes described in those other examples, even though such combination or combinations are not explicitly described or illustrated by example herein.

Referring generally to Figs. 1 and 4-13 and particularly to Fig. 3, in one or more examples, the method 2000 includes a step of applying 2002 the voltage 206 to the antenna 100. In one or more examples, the mechanical antenna 100 includes the mechanical actuator 102, the first antenna structure 108, and the second antenna structure 112. The mechanical actuator 102 includes the first side 104 and the second side 106. The first antenna structure 108 is printed on the first side 104 using the conductive ink 110. The second antenna structure 112 is printed on the second side 106 using the conductive ink 110. The method 2000 includes a step of actuating 2004 the mechanical actuator 102 in response to applying the voltage 206. The method 2000 includes a step of transmitting 2006 the radio frequency signal 204 via kinematic motion of the first antenna structure 108 and the second antenna structure 112 caused by actuating the mechanical actuator 102.

Referring generally to Figs. 1, 4 and 5 and particularly to Fig. 3, in one or more examples, according to the method 2000, the step of actuating 2004 the mechanical actuator 102 produces linear motion.

Referring generally to Figs. 1, 6 and 7 and particularly to Fig. 3, in one or more examples, according to the method 2000, the step of actuating 2004 the mechanical actuator 102 produces radial motion.

Referring generally to Fig. 1 and particularly to Fig. 3, in one or more examples, the method 2000 includes a step of varying 2008 the voltage 206 applied to the antenna 100. The method 2000 also includes a step of changing 2010 the frequency 208 of the radio frequency signal 204 transmitted by the antenna 100 in response to varying the voltage 206. In one or more examples, the third voltage 226 from the third voltage source 214 applied to the tuner 182 (e.g., the second portion 148) of the first antenna structure 108 is varied. The voltage change utilizes the electrical bias of the graphene 124 of the tuner 182 (e.g., second portion 148) of the first antenna structure 108 to change the conductivity of the graphene 124 and, thus, change or tune the frequency 208 of the radio frequency signal 204 transmitted by the antenna 100.

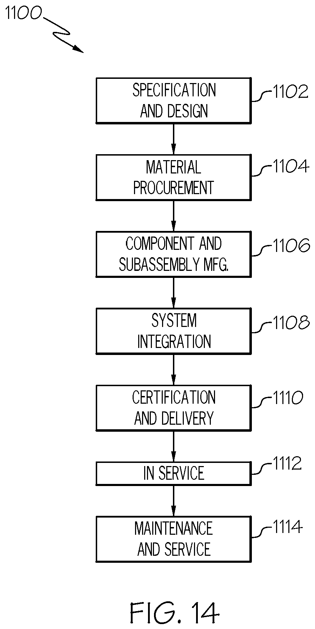

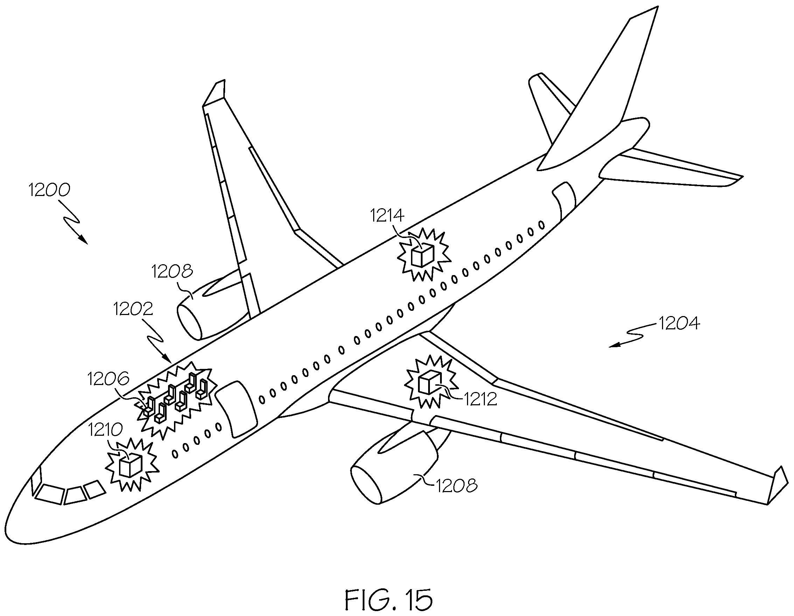

Referring now to Figs. 14 and 15, examples of the antenna 100, device 200, method 1000, and method 2000 described herein, may be related to, or used in the context of, the aerospace manufacturing and service method 1100, as shown in the flow diagram of Fig. 14 and an aircraft 1200, as schematically illustrated in Fig. 15. As an example, the aircraft 1200 and/or the manufacturing and service method 1100 may include or utilize the antenna 100 and/or the device 200, which is made according to the method 1000 and/or that operates according to the method 2000.

Referring to Fig. 15, which illustrates an example of the aircraft 1200. The aircraft 1200 can be any aerospace vehicle or platform. In one or more examples, the aircraft 1200 includes the airframe 1202 having the interior 1206. The aircraft 1200 includes a plurality of onboard systems 1204 (e.g., high-level systems). Examples of the onboard systems 1204 of the aircraft 1200 include propulsion systems 1208, hydraulic systems 1212, electrical systems 1210, and environmental systems 1214. In other examples, the onboard systems 1204 also includes one or more control systems coupled to the airframe 1202 of the aircraft 1200. In yet other examples, the onboard systems 1204 also include one or more other systems, such as, but not limited to, communications systems, avionics systems, software distribution systems, network communications systems, passenger information/entertainment systems, guidance systems, radar systems, weapons systems, and the like.

Referring to Fig. 14, during pre-production of the aircraft 1200, the manufacturing and service method 1100 includes specification and design of the aircraft 1200 (block 1102) and material procurement (block 1104). During production of the aircraft 1200, component and subassembly manufacturing (block 1106) and system integration (block 1108) of the aircraft 1200 take place. Thereafter, the aircraft 1200 goes through certification and delivery (block 1110) to be placed in service (block 1112). Routine maintenance and service (block 1114) includes modification, reconfiguration, refurbishment, etc. of one or more systems of the aircraft 1200.

Each of the processes of the manufacturing and service method 1100 illustrated in Fig. 14 may be performed or carried out by a system integrator, a third party, and/or an operator (e.g., a customer). For the purposes of this description, a system integrator may include, without limitation, any number of aircraft manufacturers and major-system subcontractors; a third party may include, without limitation, any number of vendors, subcontractors, and suppliers; and an operator may be an airline, leasing company, military entity, service organization, and so on.

Examples of the antenna 100, device 200, method 1000, and method 2000, shown and described herein, may be employed during any one or more of the stages of the manufacturing and service method 1100 shown in the flow diagram illustrated by Fig. 16. In an example, the aircraft 1200 includes the antenna 100 and/or the device 200, which is made according to the method 1000 and/or that operates according to the method 2000, during a portion of component and subassembly manufacturing (block 1106) and/or system integration (block 1108). Further, the aircraft 1200 includes the antenna 100 and/or the device 200, which is made according to the method 1000 and/or that operates according to the method 2000, while the aircraft 1200 is in service (block 1112). Also, the aircraft 1200 includes the antenna 100 and/or the device 200, which is made according to the method 1000 and/or that operates according to the method 2000, during system integration (block 1108) and certification and delivery (block 1110). Similarly, the aircraft 1200 includes the antenna 100 and/or the device 200, which is made according to the method 1000 and/or that operates according to the method 2000, while the aircraft 1200 is in service (block 1112) and during maintenance and service (block 1114).

Further, the disclosure comprises embodiments according to the following clauses:

Clause 1. An antenna comprising:

a mechanical actuator comprising a first side and a second side;
a first antenna structure printed on the first side using a conductive ink; and
a second antenna structure printed on the second side using the conductive ink.

Clause 2. The antenna of Clause 1, wherein the mechanical actuator comprises a piezoelectric actuator.

Clause 3. The antenna of Clause 2, wherein the piezoelectric actuator comprises a flexible substrate.

Clause 4. The antenna of Clause 3, wherein the piezoelectric actuator comprises a piezoelectric ceramic.

Clause 5. The antenna of any one of Clauses 1 to 4, wherein the conductive ink comprises conductive particles in a suspension medium.

Clause 6. The antenna of Clause 5, wherein the conductive particles of the first antenna structure are randomly oriented.

Clause 7. The antenna of Clause 5, wherein:

each of the conductive particles comprises a long axis, a first end, and a second end, opposite the first end along the long axis; and

the conductive particles of the first antenna structure are aligned such that the first end of one of the conductive particles is in contact with the second end of a directly adjacent one of the conductive particles and the long axis of the one of the conductive particles is at least approximately parallel to the directly adjacent one of the conductive particles.

Clause 8. The antenna of any one of Clauses 5 to 7, wherein the conductive particles comprise graphene.

Clause 9. The antenna of any one of Clauses 5 to 7, wherein the conductive particles comprise copper.

Clause 10. The antenna of any one of Clauses 5 to 7, wherein the conductive particles comprise silver.

Clause 11. The antenna of any one of Clauses 5 to 7, wherein the conductive particles comprise gold.

Clause 12. The antenna of any one of Clauses 1 to 11, wherein the conductive ink comprises an inverse Ohnesorge number of between approximately 1 $Oh^{-1}$ and 10 $Oh^{-1}$.

Clause 13. The antenna of any one of Clauses 1 to 12, wherein:

the first antenna structure comprises:

a first portion that is printed on the first side using a first conductive ink comprising first conductive particles; and

a second portion that is printed on the first side using a second conductive ink comprising second conductive particles; and

the first conductive particles and the second conductive particles are different.

Clause 14. The antenna of Clause 13, wherein:

the first conductive particles of the first conductive ink comprise at least one of copper, gold, and silver; and

the second conductive particles of the second conductive ink comprises graphene.

Clause 15. The antenna of Clauses 13 or 14, wherein the first portion of the first antenna structure comprises a complex shape.

Clause 16. The antenna of any one of Clauses 1 to 15, wherein:

the first antenna structure comprises a first thickness; and

the first thickness is constant along the first side.

Clause 17. The antenna of any one of Clauses 1 to 16, wherein:

the second antenna structure comprises a second thickness; and

the second thickness is constant along the second side.

Clause 18. The antenna of any one of Clauses 1 to 17, wherein the mechanical actuator produces linear motion.

Clause 19. The antenna of any one of Clauses 1 to 17, wherein the mechanical actuator produces radial motion.

Clause 20. The antenna of any one of Clauses 1 to 19, wherein the first antenna structure comprises:

a emitter; and

a feed.

Clause 21. The antenna of Clause 20, wherein the first antenna structure further comprises a tuner extending between the emitter and the feed.

Clause 22. The antenna of Clause 21, wherein:

the emitter and the feed comprise at least one of copper, silver, and gold; and
the tuner comprises graphene.

Clause 23. A radio frequency device comprising:

a voltage source; and
an antenna electrically coupled to the voltage source, wherein the antenna comprises:

a mechanical actuator comprising a first side and a second side;
a first antenna structure printed on the first side using a conductive ink; and
a second antenna structure printed on the second side using the conductive ink,

wherein the antenna transmits a radio frequency signal via kinematic motion of the first antenna structure and the second antenna structure caused by actuation of the mechanical actuator.

Clause 24. The device of Clause 23, wherein the mechanical actuator comprises a piezoelectric actuator.
Clause 25. The device of Clause 24, wherein the piezoelectric actuator comprises a flexible substrate.
Clause 26. The device of Clause 24, wherein the piezoelectric actuator comprises a piezoelectric ceramic.
Clause 27. The device of any one of Clauses 23 to 26, wherein the conductive ink comprises conductive particles in a suspension medium.
Clause 28. The device of Clause 27, wherein the conductive particles of the first antenna structure are randomly oriented.
Clause 29. The device of Clause 27, wherein:

each of the conductive particles comprises a long axis, a first end, and a second end, opposite the first end along the long axis; and
the conductive particles of the first antenna structure are aligned such that the first end of one of the conductive particles is in contact with the second end of a directly adjacent one of the conductive particles and the long axis of the one of the conductive particles is at least approximately parallel to the directly adjacent one of the conductive particles.

Clause 30. The device of any one of Clauses 27 to 29, wherein the conductive particles comprise graphene.
Clause 31. The device of any one of Clauses 27 to 29, wherein the conductive particles comprise copper.
Clause 32. The device of any one of Clauses 27 to 29, wherein the conductive particles comprise silver.
Clause 33. The device of any one of Clauses 27 to 29, wherein the conductive particles comprise gold.
Clause 34. The device of any one of Clauses 23 to 33, wherein the conductive ink comprises an inverse Ohnesorge number of between approximately 1 $Oh^{-1}$ and 10 $Oh^{-1}$.
Clause 35. The device of any one of Clauses 23 to 34, wherein:

the first antenna structure comprises:

a first portion that is printed on the first side using a first conductive ink comprising first conductive particles; and
a second portion that is printed on the first side using a second conductive ink comprising second conductive particles; and

the first conductive particles and the second conductive particles are different.

Clause 36. The device of Clause 35, wherein:

the first conductive particles of the first conductive ink comprise at least one of copper, gold, and silver; and
the second conductive particles of the second conductive ink comprises graphene. Clause 37. The device of Clauses 35 or 36, wherein the first portion of the first antenna structure comprises a complex shape.

Clause 38. The device of any one of Clauses 23 to 37, wherein:

the first antenna structure comprises a first thickness; and
the first thickness is constant along the first side.

Clause 39. The device of any one of Clauses 23 to 38, wherein:

the second antenna structure comprises a second thickness; and
the second thickness is constant along the second side.

Clause 40. The device of any one of Clauses 23 to 39, wherein the mechanical actuator produces linear motion.
Clause 41. The device of any one of Clauses 23 to 39, wherein the mechanical actuator produces radial motion.
Clause 42. A method for making an antenna, the method comprising:

providing a mechanical actuator;
printing a first antenna structure on a first side of the mechanical actuator using a conductive ink; and
printing a second antenna structure on a second side of the mechanical actuator using the conductive ink.

Clause 43. The method of Clause 42, further comprising randomly orienting conductive particles of the first antenna structure during printing.
Clause 44. The method of Clause 42, further comprising aligning conductive particles of the first antenna structure during printing such that a first end of one of the conductive particles is in contact with a second end of a directly adjacent one of the conductive particles and a long axis of the one of the conductive particles is at least approximately parallel to the directly adjacent one of the conductive particles.
Clause 45. The method of any one of Clauses 42 to 44, further comprising selecting the conductive ink comprising an inverse Ohnesorge number of between approximately 1 Oh$^{-1}$ and 10 Oh$^{-1}$.
Clause 46. The method of any one of Clauses 42 to 45, further comprising selecting the conductive ink comprising conductive particles made of graphene.
Clause 47. The method of any one of Clauses 42 to 45, further comprising selecting the conductive ink comprising conductive particles made of copper.
Clause 48. The method of any one of Clauses 42 to 45, further comprising selecting the conductive ink comprising conductive particles made of silver.
Clause 49. The method of any one of Clauses 42 to 45, further comprising selecting the conductive ink comprising conductive particles made of gold.
Clause 50. The method of any one of Clauses 42 to 49, wherein:

printing the first antenna structure comprises:

printing a first portion on the first side using a first conductive ink comprising first conductive particles; and
printing a second portion on the first side using a second conductive ink comprising second conductive particles; and

the first conductive particles and the second conductive particles are different.

Clause 51. The method of Clause 50, wherein printing the first portion comprises printing the first portion in a complex shape.
Clause 52. The method of any one of Clauses 42 to 51, wherein printing the first antenna structure comprises printing the first antenna structure having a first thickness that is constant along the first side.
Clause 53. The method of any one of Clauses 42 to 52, wherein printing the second antenna structure comprises printing the second antenna structure having a second thickness that is constant along the second side.
Clause 54. The method of any one of Clauses 42 to 45, 52 and 53, wherein printing the first antenna structure comprises:

printing an emitter and a feed on the first side using a first conductive ink comprising first conductive particles; and
printing a tuner on the first side between the emitter and the feed using a second conductive ink comprising second conductive particles; and

the first conductive particles comprise at least one of copper, silver, and gold; and
the second conductive particles comprise graphene.

Clause 55. A method for transmitting a radio frequency signal, the method comprising:

applying a voltage to an antenna, wherein the antenna comprises:

a mechanical actuator comprising a first side and a second side;
a first antenna structure printed on the first side using a conductive ink; and
a second antenna structure printed on the second side using the conductive ink;

actuating the mechanical actuator in response to the applying the voltage; and
transmitting the radio frequency signal via kinematic motion of the first antenna structure and the second antenna structure caused by actuating the mechanical actuator.

Clause 56. The method of Clause 55, wherein actuating the mechanical actuator produces linear motion.
Clause 57. The method of Clause 55, wherein actuating the mechanical actuator produces radial motion.
Clause 58. The method of any one of Clauses 55 to 57, further comprising:

varying the voltage applied to the antenna; and
changing a frequency of the radio frequency signal transmitted by the antenna.

The preceding detailed description refers to the accompanying drawings, which illustrate specific examples described by the present disclosure. Other examples having different structures and operations do not depart from the scope of the present disclosure. Like reference numerals may refer to the same feature, element, or component in the different drawings. Throughout the present disclosure, any one of a plurality of items may be referred to individually as the item and a plurality of items may be referred to collectively as the items and may be referred to with like reference numerals. Moreover, as used herein, a feature, element, component, or step preceded with the word "a" or "an" should be understood as not excluding a plurality of features, elements, components, or steps, unless such exclusion is explicitly recited.

Illustrative, non-exhaustive examples, which may be, but are not necessarily, claimed, of the subject matter according to the present disclosure are provided above. Reference herein to "example" means that one or more feature, structure, element, component, characteristic, and/or operational step described in connection with the example is included in at least one aspect, embodiment, and/or implementation of the subject matter according to the present disclosure. Thus, the phrases "an example," "another example," "one or more examples," and similar language throughout the present disclosure may, but do not necessarily, refer to the same example. Further, the subject matter characterizing any one example may, but does not necessarily, include the subject matter characterizing any other example. Moreover, the subject matter characterizing any one example may be, but is not necessarily, combined with the subject matter characterizing any other example.

As used herein, a system, apparatus, device, structure, article, element, component, or hardware "configured to" perform a specified function is indeed capable of performing the specified function without any alteration, rather than merely having potential to perform the specified function after further modification. In other words, the system, apparatus, device, structure, article, element, component, or hardware "configured to" perform a specified function is specifically selected, created, implemented, utilized, programmed, and/or designed for the purpose of performing the specified function. As used herein, "configured to" denotes existing characteristics of a system, apparatus, structure, article, element, component, or hardware that enable the system, apparatus, structure, article, element, component, or hardware to perform the specified function without further modification. For purposes of this disclosure, a system, apparatus, device, structure, article, element, component, or hardware described as being "configured to" perform a particular function may additionally or alternatively be described as being "adapted to" and/or as being "operative to" perform that function.

Unless otherwise indicated, the terms "first," "second," "third," etc. are used herein merely as labels, and are not intended to impose ordinal, positional, or hierarchical requirements on the items to which these terms refer. Moreover, reference to, e.g., a "second" item does not require or preclude the existence of, e.g., a "first" or lower-numbered item, and/or, e.g., a "third" or higher-numbered item.

As used herein, the phrase "at least one of," when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of' may be, for example, without limitation, two of item A, one of item B, and ten of item C; four of item B and seven of item C; and other suitable combinations. As used herein, the term "and/or" and the "j" symbol includes any and all combinations of one or more of the associated listed items.

For the purpose of this disclosure, the terms "coupled," "coupling," and similar terms refer to two or more elements that are joined, linked, fastened, attached, connected, put in communication, or otherwise associated (e.g., mechanically, electrically, fluidly, optically, electromagnetically) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the term "approximately" refers to or represents a condition that is close to, but not exactly, the stated condition that still performs the desired function or achieves the desired result. As an example, the term "approximately" refers to a condition that is within an acceptable predetermined tolerance or accuracy, such as to a condition that is within 10% of the stated condition. However, the term "approximately" does not exclude a condition that is exactly the stated condition. As used herein, the term "substantially" refers to a condition that is essentially the stated condition that performs the desired function or achieves the desired result.

Figs. 1, 3-13 and 15, referred to above, may represent functional elements, features, or components thereof and do not necessarily imply any particular structure. Accordingly, modifications, additions and/or omissions may be made to the illustrated structure. Additionally, those skilled in the art will appreciate that not all elements, features, and/or components described and illustrated in Figs. 1, 3-13 and 15, referred to above, need be included in every example and not all elements, features, and/or components described herein are necessarily depicted in each illustrative example. Accordingly, some of the elements, features, and/or components described and illustrated in Figs. 1, 3-13 and 15may be combined in various ways without the need to include other features described and illustrated in Figs. 1, 3-13 and 15, other drawing figures, and/or the accompanying disclosure, even though such combination or combinations are not explicitly illustrated herein. Similarly, additional features not limited to the examples presented, may be combined with some or all of the features shown and described herein. Unless otherwise explicitly stated, the schematic illustrations of the examples depicted in Figs. 1, 3-13 and 15, referred to above, are not meant to imply structural limitations with respect to the illustrative example. Rather, although one illustrative structure is indicated, it is to be understood that the structure may be modified when appropriate. Accordingly, modifications, additions and/or omissions may be made to the illustrated structure. Furthermore, elements, features, and/or components that serve a similar, or at least substantially similar, purpose are labeled with like numbers in each of Figs. 1, 3-13 and 15, and such elements, features, and/or components may not be discussed in detail herein with reference to each of Figs. 1, 3-13 and 15. Similarly, all elements, features, and/or components may not be labeled in each of Figs. 1, 3-13 and 15, but reference numerals associated therewith may be utilized herein for consistency.

In Figs. 2, 3 and 14, referred to above, the blocks may represent operations, steps, and/or portions thereof and lines connecting the various blocks do not imply any particular order or dependency of the operations or portions thereof. It will be understood that not all dependencies among the various disclosed operations are necessarily represented. Figs. 2, 3 and 14 and the accompanying disclosure describing the operations of the disclosed methods set forth herein should not be interpreted as necessarily determining a sequence in which the operations are to be performed. Rather, although one illustrative order is indicated, it is to be understood that the sequence of the operations may be modified when appropriate. Accordingly, modifications, additions and/or omissions may be made to the operations illustrated and certain operations may be performed in a different order or simultaneously. Additionally, those skilled in the art will appreciate that not all operations described need be performed.

Further, references throughout the present specification to features, advantages, or similar language used herein do not imply that all of the features and advantages that may be realized with the examples disclosed herein should be, or are in, any single example. Rather, language referring to the features and advantages is understood to mean that a specific feature, advantage, or characteristic described in connection with an example is included in at least one example. Thus, discussion of features, advantages, and similar language used throughout the present disclosure may, but does not necessarily, refer to the same example.

The described features, advantages, and characteristics of one example may be combined in any suitable manner in one or more other examples. One skilled in the relevant art will recognize that the examples described herein may be practiced without one or more of the specific features or advantages of a particular example. In other instances, additional features and advantages may be recognized in certain examples that may not be present in all examples. Furthermore, although various examples of the antenna 100, device 200, method 1000, and method 2000 have been shown and described, modifications may occur to those skilled in the art upon reading the specification. The present application includes such modifications and is limited only by the scope of the claims.

**Claims**

1. An antenna (100) comprising:

    a mechanical actuator (102) comprising a first side (104) and a second side (106);
    a first antenna structure (108) printed on the first side (104) using a conductive ink (110); and

a second antenna structure (112) printed on the second side (106) using the conductive ink (110).

2. The antenna (100) of Claim 1, wherein the mechanical actuator (102) comprises a piezoelectric actuator (114), wherein the piezoelectric actuator (114) preferably comprises a flexible substrate (132), and wherein the piezoelectric actuator (114) preferably comprises a piezoelectric ceramic (170).

3. The antenna (100) of any one of Claims 1 or 2, wherein the conductive ink (110) comprises conductive particles (120) in a suspension medium (122), wherein the conductive particles (120) of the first antenna structure (108) are preferably randomly oriented, and/or wherein preferably:

    each of the conductive particles (120) comprises a long axis (126), a first end (128), and a second end (130), opposite the first end (128) along the long axis (126); and
    the conductive particles (120) of the first antenna structure (108) are aligned such that the first end (128) of one of the conductive particles (120) is in contact with the second end (130) of a directly adjacent one of the conductive particles (120) and the long axis (126) of the one of the conductive particles (120) is at least approximately parallel to the directly adjacent one of the conductive particles (120).

4. The antenna (100) of Claim3 3, wherein the conductive particles (120) comprise at least one of graphene (124) copper (172), silver (176), or gold (174).

5. The antenna (100) of any one of Claims 1 to 4, wherein the conductive ink (110) comprises an inverse Ohnesorge number (140) of between approximately 1 Oh$^{-1}$ and 10 Oh$^{-1}$.

6. The antenna (100) of any one of Claims 1 to 5, wherein:

    the first antenna structure (108) comprises:

        a first portion (142) that is printed on the first side (104) using a first conductive ink (144) comprising first conductive particles (146); and
        a second portion (148) that is printed on the first side (104) using a second conductive ink (150) comprising second conductive particles (152); and

    the first conductive particles (146) and the second conductive particles (152) are different.

7. The antenna (100) of Claim 6, wherein:

    the first conductive particles (146) of the first conductive ink (144) comprise at least one of copper (172), gold (174), and silver (176); and
    the second conductive particles (152) of the second conductive ink (150) comprises graphene (124).

8. The antenna (100) of Claims 6 or 7, wherein the first portion (142) of the first antenna structure (108) comprises a complex shape (154).

9. The antenna (100) of any one of Claims 1 to 8, wherein:

    the first antenna structure (108) comprises a first thickness (116); and
    the first thickness (116) is constant along the first side (104).

10. The antenna (100) of any one of Claims 1 to 9, wherein:

    the second antenna structure (112) comprises a second thickness (118); and
    the second thickness (118) is constant along the second side (106).

11. The antenna (100) of any one of Claims 1 to 10, wherein the mechanical actuator (102) produces linear motion.

12. The antenna (100) of any one of Claims 1 to 11, wherein the mechanical actuator (102) produces radial motion.

13. The antenna (100) of any one of Claims 1 to 12, wherein the first antenna structure (108) comprises:

an emitter (178); and

a feed (180); wherein the first antenna structure (108) preferably further comprises a tuner (182) extending between the emitter (178) and the feed (180); and wherein preferably:

the emitter (178) and the feed (180) comprise at least one of copper (172), silver (176), and gold (174); and the tuner (182) comprises graphene (124).

14. A radio frequency device (200) comprising:

a voltage source (202); and
an antenna (100) electrically coupled to the voltage source (202), wherein the antenna (100) comprises:

a mechanical actuator (102) comprising a first side (104) and a second side (106);
a first antenna structure (108) printed on the first side (104) using a conductive ink (110); and
a second antenna structure (112) printed on the second side (106) using the conductive ink (110),

wherein the antenna (100) transmits a radio frequency signal (204) via kinematic motion of the first antenna structure (108) and the second antenna structure (112) caused by actuation of the mechanical actuator (102).

15. A method (1000) for making an antenna (100), the method (1000) comprising:

providing (1002) a mechanical actuator (102);
printing (1006) a first antenna structure (108) on a first side (104) of the mechanical actuator (102) using a conductive ink (110); and
printing (1016) a second antenna structure (112) on a second side (106) of the mechanical actuator (102) using the conductive ink (110).

FIG. 1

1000

```
                                    ┌─────────┐
                                    │  START  │
                                    └────┬────┘
                                         │
                        ┌────────────────▼─────────────────┐
                        │  PROVIDE MECHANICAL ACTUATOR      │
                        │              1002                 │
                        └────────────────┬─────────────────┘
                                         │
                        ┌────────────────▼─────────────────┐
                        │     SELECT CONDUCTIVE INK         │
                        │              1004                 │
                        └────────────────┬─────────────────┘
                                         │
              ┌──────────────────────────▼──────────────────────────┐
              │        PRINT FIRST ANTENNA STRUCTURE                 │
              │                    1006                              │
              │   ┌──────────────────────────────────────────────┐  │
┌─────────────┐│   │           PRINT FIRST PORTION                │  │
│ RANDOMLY    ││   │                 1008                         │  │
│ ORIENT      ││   │   ┌──────────────────────────────────────┐   │  │
│ CONDUCTIVE  │───▶│   │      PRINT COMPLEX SHAPE              │   │  │
│ PARTICLES   ││   │   │            1010                      │   │  │
│      1020   ││   │   └──────────────────────────────────────┘   │  │
└─────────────┘│   └──────────────────────────────────────────────┘  │
               │                      │                               │
┌─────────────┐│   ┌──────────────────▼──────────────────┐           │
│ ALIGN       ││   │        PRINT SECOND PORTION          │           │
│ CONDUCTIVE  │───▶│              1012                    │           │
│ PARTICLES   ││   └──────────────────┬──────────────────┘           │
│      1022   ││                      │                               │
└─────────────┘│   ┌──────────────────▼──────────────────┐           │
               │   │        PRINT FIRST THICKNESS         │           │
               │   │              1014                    │           │
               │   └──────────────────────────────────────┘           │
               └──────────────────────┬──────────────────────────────┘
                                      │
                     ┌────────────────▼─────────────────┐
                     │  PRINT SECOND ANTENNA STRUCTURE   │
                     │              1016                 │
                     │  ┌─────────────────────────────┐  │
                     │  │  PRINT SECOND THICKNESS      │  │
                     │  │          1018               │  │
                     │  └─────────────────────────────┘  │
                     └────────────────┬─────────────────┘
                                      │
                                 ┌────▼────┐
                                 │   END   │
                                 └─────────┘
```

FIG. 2

2000

FIG. 3

FIG. 4

FIG. 5

FIG. 6

FIG. 7

FIG. 8

FIG. 9

FIG. 10

FIG. 11

EP 4 597 747 A1

FIG. 12

FIG. 13

1100

```
                    ┌─────────────────┐
                    │  SPECIFICATION  │───1102
                    │   AND DESIGN    │
                    └─────────────────┘
                             │
                             ▼
                    ┌─────────────────┐
                    │    MATERIAL     │───1104
                    │   PROCUREMENT   │
                    └─────────────────┘
                             │
                             ▼
                    ┌─────────────────┐
                    │  COMPONENT AND  │───1106
                    │ SUBASSEMBLY MFG.│
                    └─────────────────┘
                             │
                             ▼
                    ┌─────────────────┐
                    │     SYSTEM      │───1108
                    │   INTEGRATION   │
                    └─────────────────┘
                             │
                             ▼
                    ┌─────────────────┐
                    │  CERTIFICATION  │───1110
                    │   AND DELIVERY  │
                    └─────────────────┘
                             │
                             ▼
                    ┌─────────────────┐
                    │    IN SERVICE   │───1112
                    └─────────────────┘
                             │
                             ▼
                    ┌─────────────────┐
                    │   MAINTENANCE   │───1114
                    │   AND SERVICE   │
                    └─────────────────┘
```

FIG. 14

FIG. 15

Europäisches
Patentamt

European
Patent Office

Office européen
des brevets

# EUROPEAN SEARCH REPORT

**Application Number**

EP 24 22 1774

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/288403 A1 (HASSANIEN AHMED [US] ET AL) 16 September 2021 (2021-09-16)<br>* figure 3A *<br>* figure 3B *<br>* figure 3C *<br>* paragraph [0051] - paragraph [0053] *<br>* paragraph [0055] *<br>----- | 1,2, 9-12,14 | INV.<br>H01Q3/01<br>H01Q1/36 |
| X | WO 2020/244743 A1 (ESA [FR]; UNIV DEGLI STUDI DI SIENA [IT]) 10 December 2020 (2020-12-10)<br>* figure 3 *<br>* page 14, line 8 - line 12 *<br>* page 15, line 6 - line 34 *<br>* page 19, line 15 - line 24 *<br>----- | 1-11,13, 15 | |
| X | US 2012/154248 A1 (HAQUE SAMIUL [GB] ET AL) 21 June 2012 (2012-06-21)<br>* figure 3b *<br>* paragraph [0012] *<br>* paragraph [0059] - paragraph [0063] *<br>----- | 1,2,9,12 | |
| X | CN 116 315 618 B (UNIV ANHUI) 31 October 2023 (2023-10-31)<br>* figure 1 *<br>* paragraph [0024] *<br>----- | 1,2,10, 14 | **TECHNICAL FIELDS SEARCHED (IPC)**<br><br>H01Q |
| X | CN 114 430 105 B (UNIV ANHUI) 10 March 2023 (2023-03-10)<br>* figure 2 *<br>* paragraph [0022] *<br>* paragraph [0024] - paragraph [0027] *<br>----- | 1,2,9, 10,14 | |

The present search report has been drawn up for all claims

| Place of search | Date of completion of the search | Examiner |
|---|---|---|
| The Hague | 8 May 2025 | Kalialakis, Christos |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 22 1774

This annex lists the patent family members relating to the patent documents cited in the above-mentioned European search report.
The members are as contained in the European Patent Office EDP file on
The European Patent Office is in no way liable for these particulars which are merely given for the purpose of information.

08-05-2025

| Patent document cited in search report | Publication date | Patent family member(s) | Publication date |
|---|---|---|---|
| US 2021288403 A1 | 16-09-2021 | NONE | |
| WO 2020244743 A1 | 10-12-2020 | NONE | |
| US 2012154248 A1 | 21-06-2012 | CN 103262343 A | 21-08-2013 |
| | | EP 2652838 A1 | 23-10-2013 |
| | | US 2012154248 A1 | 21-06-2012 |
| | | WO 2012080562 A1 | 21-06-2012 |
| CN 116315618 B | 31-10-2023 | NONE | |
| CN 114430105 B | 10-03-2023 | NONE | |

EPO FORM P0459

For more details about this annex : see Official Journal of the European Patent Office, No. 12/82